**Europäisches Patentamt**

**European Patent Office**

**Office européen des brevets**

(19)

(11) Veröffentlichungsnummer: **0 161 427**
A2

## (12) EUROPÄISCHE PATENTANMELDUNG

(21) Anmeldenummer: 85103341.5

(22) Anmeldetag: 22.03.85

(51) Int. Cl.⁴: **G 11 C 13/04**, G 11 B 7/00, G 11 B 11/00

(30) Priorität: 16.05.84 DE 3418190

(43) Veröffentlichungstag der Anmeldung: 21.11.85
Patentblatt 85/47

(84) Benannte Vertragsstaaten: **CH DE FR GB LI NL**

(71) Anmelder: **ERNST LEITZ WETZLAR GMBH,
Ernst-Leitz-Strasse 30 Postfach 20 20,
D-6330 Wetzlar 1 (DE)**

(72) Erfinder: **Heitmann, Knut, Dipl.-Ing., Lerchenweg 16,
D-6330 Wetzlar (DE)**
Erfinder: **Hoppe, Martin, Dr. Dipl.-Min.,
Helgebachstrasse 29, D-6330 Wetzlar (DE)**
Erfinder: **Schneider, Eckhard, Lauerstrasse 3,
D-6330 Wetzlar (DE)**
Erfinder: **Thaer, Andreas, Dr.rer.nat, Steinweg 8,
D-6301 Leihgestern (DE)**

(54) Verfahren zur Datenspeicherung in und Datenauslesung aus Resistschichten.

(57) Ein Verfahren zur Datenspeicherung in Resistschichten zeichnet sich dadurch aus, daß die Datenspeicherung ausschließlich durch eine die Oberflächenstruktur nicht verändernde, aber eine Polymerisation bzw. Depolymerisation in der Resistschicht auslösende Bestrahlung erfolgt. Zum Auslesen der gespeicherten Daten wird die bestrahlte, chemisch nicht entwickelte Resistschicht mit einem fein gebündelten Ultraschallstrahl abgetastet und die von der Resistschicht ausgehenden Ultraschallstrahlen werden detektiert und in elektrische Signale umgewandelt.

EP 0 161 427 A2

ACTORUM AG

0161427

Verfahren zur Datenspeicherung in und
Datenauslesung aus Resistschichten
========================================

Die Erfindung betrifft ein Verfahren zur Datenspeicherung in Resistschichten und ein Verfahren zum Auslesen
der gespeicherten Daten.

Als Resist wird allgemein eine solche Masse verstanden, die auf eine Substratoberfläche aufgebracht werden kann und den von ihr bedeckten Teil maskiert, d.h.
dem Angriff von Agentien, z.B. Ätzmitteln, chemischen
oder galvanischen Metallisierungsbädern entzieht. Resiste werden im wesentlichen nach ihren Löslichkeitsänderungen unterschieden, die sie nach Bestrahlung
mit elektromagnetischen Wellen erfahren. Zur Bestrahlung werden am häufigsten kurzwellige UV-Strahlen,
Elektronen-, Ionen- oder Röntgenstrahlen verwendet.
Es sollen hier aber auch Wärmestrahlen eingeschlossen
werden, soweit sie in dem Resist die typische, für
die Löslichkeitsänderung verantwortliche Fragmentierung (Depolymerisation) oder Vernetzung der Polymerstruktur erzeugen. Bekannte Vertreter der Resiste sind Fotolacke und Harze. Die Eigenschaft der Löslichkeitsänderung in den bestrahlten bzw. nicht bestrahlten Flächenbereichen wird ausgenutzt, um durch nachfolgende chemische Entwicklungsprozesse ein Auswaschrelief auf der Substratoberfläche zu erzeugen. Der Bestrahlungsvorgang selbst führt zu keiner sichtbaren Veränderung in der Resistbeschichtung der Substratoberfläche.

Auf dem Gebiet der Datenspeicherung besteht ein wachsendes Bedürfnis, immer mehr Daten auf immer kleinerem Raum sicher speichern und wieder auslesen zu können. Eine sehr hohe digitale Speicherdichte wird derzeit unter Ausnutzung magneto-optischer Eigenschaften bestimmter amorpher Legierungen erreicht. Die Aufzeichnung der Information erfolgt in der Weise, daß die Orientierung oder die Richtung einer vorhandenen Vormagnetisierung bei Anliegen eines schwachen äußeren magnetischen Feldes durch Zuführung zusätzlicher Energie lokal umgekehrt wird. Das Auslesen der Information erfolgt unter Ausnutzung des magnetischen Kerr-Effektes, bei dem ein linear polarisierter Laserstrahl durch Wechselwirkung mit der Magnetisierung des Speichermediums seine Polarisationsrichtung ändert. Neben dem erheblichen technischen Aufwand haftet diesem System der Nachteil an, daß bereits durch kurzzeitige Einwirkung entsprechend starker äußerer Magnetfelder der Speicherinhalt zerstört wird.

0161427

Die Gefährdung des Speicherinhalts beispielsweise durch Einwirkung eines Nuclear Electro-Magnetic Pulses (NEMP) ist ein prinzipieller Nachteil, der allen mit elektrischer oder magnetischer Dipolausrichtung arbeitenden Speichern anhaftet. Er wird vermieden bei Verwendung von Speichermedien, die ausschließlich fotochemisch empfindlich sind. Die höchste Strukturauflösung zeigen hierbei die z.B. für die Halbleitertechnologie entwikkelten Resistschichten, zu denen insbesondere die Fotolacke gehören. Für Zwecke einer rationellen Datenspeicherung scheinen diese Materialien jedoch nicht geeignet zu sein, da sie nach dem Einschreiben der Information weitere chemische Entwicklungs- und Aufdampfprozesse durchlaufen müssen, um die Information für eine optische Auslesung aufzubereiten.

Der Erfindung lag die Aufgabe zugrunde, ein Verfahren zur Datenspeicherung anzugeben, das eine möglichst große Speicherdichte erlaubt, unempfindlich gegen äußere elektro-magnetische Fremdfelder ist und sowohl beim Einschreiben als auch beim Auslesen mit sehr geringem instrumentellen Aufwand zu handhaben ist.

Diese Aufgabe wird erfindungsgemäß durch die im kennzeichnenden Teil der Ansprüche 1 und 3 angegebenen Merkmale gelöst. Vorteilhafte Ausgestaltungen und Weiterbildungen der Verfahren ergeben sich aus den Unteransprüchen 2 und 4 bis 7.

Der Erfindung liegt die Erkenntnis zugrunde, daß die beim Einschreiben einer Information in einer Resistschicht ablaufenden Polymerisations- oder Depolymerisationsvorgäng zu einer inneren Strukturveränderung führen, die sich mit Hilfe einer akustischen Linsenanordnung nachweisen läßt.

Aus der akustischen Mikroskopie ist es an sich bekannt, daß Ultraschallstrahlen mit solchen Objektstrukturen wechselwirken, die die elastischen Eigenschaften des Objekts bestimmen. Es war aber nicht zu erwarten, daß die fotochemisch induzierten Fragmentierungs- oder Vernetzungsbereiche in Resistschichten, wie sie anfangs beschrieben wurden, ohne weiteres zu einem akustomikroskopisch nachweisbaren Signal führen. In überraschender Weise wurde jedoch gefunden, daß sich mit dem in der akustischen Mikroskopie erreichbaren Auflösungsvermögen die bestrahlten und die nicht bestrahlten Flächenbereiche voneinander unterscheiden lassen, ohne daß die Resistschicht nach der Bestrahlung weiter behandelt zu werden braucht. Damit wurde ein äußerst einfach handhabbares Aufzeichnungsverfahren gefunden, das Speicherdichten erlaubt, die letztlich nur vom Fo-, kusdurchmesser der für die Auslesung benutzten akustischen Linsenanordnung begrenzt werden. Fokusdurchmesser von 1 $\mu$ sind bei Ultraschallfrequenzen von 2 GHz ohne weiteres zu erreichen. Eine Verkleinerung des Fleckdurchmessers um den Faktor 10 konnte bei höheren Ultraschallfrequenzen ebenfalls schon verwirklicht werden, so daß sogar eine höhere Speicherdichte erlaubt sein wird als z.B. bei den bekannten magnetischen Blasenspeichern.

Neben dem Vorteil des Wegfalls aller weiteren chemischen Prozesse läßt sich die fertige Datenträgerschicht noch in einfacher Weise gegen mechanische Beschädigungen oder unerwünschtes Überschreiben schützen. Dazu wird auf die Resistschicht eine Schutzschicht, z.B. aus Aluminium, aufgedampft, die für die polymerisierende oder depolymerisierende Strahlung undurchlässig, für Ultraschallstrahlen aber durchlässig ist. Die Haftung einer solchen Schutzschicht auf der Resistfläche ist sehr gut.

Die Abtastung der mit Informationen beschriebenen Resistschicht mit einem fein gebündelten Ultraschallstrahl kann entweder bei örtlich feststehendem Ultraschallstrahl und bewegtem Datenträger erfolgen oder umgekehrt bei feststehendem Datenträger und einem eine rasterförmige Bewegung ausführenden akustischen Objektiv. Sie kann außerdem sowohl in Transmission oder in Reflektion erfolgen. Bei Durchstrahlung des Datenträgers kann z.B. ein von einem ersten akustischen Linsensystem kontinuierlich gesendeter Ultraschallstrahl verwendet werden, der durch den Datenträger moduliert und von einem zweiten akustischen Linsensystem detektiert wird. Das zweite akustische Linsensystem kann auch auf derselben Seite wie das erste angeordnet werden, wenn die Strahlungsachsen beider Objektive einen Winkel miteinander bilden. Vorteilhaft ist jedoch eine in Reflektion arbeitende Leseanordnung, die nur aus einer einzigen akustischen Linsenanordnung besteht, die in zeitlichem Wechsel ein Ultraschallstrahlenbündel auf den Datenträger richtet und das von ihm reflektierte Strahlenbündel detektiert. Solche Anordnungen sind aus der akustischen Mikroskopie bekannt und können für den erfindungsgemäßen Verwendungszweck direkt übernommen werden. Die akustische Kopplung zwischen dem Ultraschallsende- und -empfangssystem wird z.B. durch einen Wassertropfen hergestellt. Auch hierin zeigt sich der besondere Vorteil des beschriebenen Datenspeicher- und -Lesesystems, da sowohl die ungeschützte Resistschicht als auch eine mit einer Deckschicht versehene Resistschicht durch das akustische Kopplungsmittel nicht beeinflußt werden.

Die die gespeicherte Information darstellenden Veränderungen innerhalb der Resistschicht verursachen in erster Linie Amplitudenänderungen im Ultraschallstrahlenbündel beim Übergang von einer Datenbitzone zur anderen. Insbesondere bei gepulster Abtastung kann jedoch auch die Phasendifferenz zwischen dem ausgesendeten und dem detektierten Ultraschallstrahlenbündel gemessen und als Auswertesignal verwendet werden. Das ist dann zweckmäßig, wenn die unterschiedlichen Amplitudenänderungen in den Datenbitzonen aufgrund eines ungünstigen Signal/Rauschverhältnisses nicht sicher getrennt werden können.

0161427

A n s p r ü c h e

1. Verfahren zur Datenspeicherung in Resistschichten, d a d u r c h   g e k e n n z e i c h n e t , daß die Datenspeicherung ausschließlich durch eine die Oberflächenstruktur nicht verändernde, aber eine Polymerisation bzw. Depolymerisation in der Resistschicht auslösende Bestrahlung erfolgt.

2. Verfahren nach Anspruch 1, d a d u r c h   g e - k e n n z e i c h n e t , daß die bestrahlte Resistschicht mit einer Schutzschicht versehen wird, die für die polymerisierende bzw. depolymerisierende Strahlung undurchlässig ist.

3. Verfahren zum Auslesen der nach den Ansprüchen 1 oder 2 gespeicherten Daten, d a d u r c h   g e - k e n n z e i c h n e t , daß die bestrahlte, chemisch nicht entwickelte Resistschicht mit einem fein gebündelten Ultraschallstrahl abgetastet und die von der Resistschicht ausgehenden Ultraschallstrahlen detektiert und in elektrische Signale um-

0161427

gewandelt werden.

4. Verfahren nach Anspruch 3, d a d u r c h   g e -
k e n n z e i c h n e t ,   daß die Abtastung mit
einer auf die Ebene der Resistschicht fokussierten
akustischen Linsenanordnung erfolgt, wobei die
akustische Kopplung zwischen der Linsenanordnung
und der Resistschicht durch ein geeignetes Immersionsmittel hergestellt wird.

5. Verfahren nach einem der Ansprüche 3 oder 4,
d a d u r c h   g e k e n n z e i c h n e t ,
daß die Abtastung in Reflektion erfolgt.

6. Verfahren nach Anspruch 5, d a d u r c h   g e -
k e n n z e i c h n e t ,   daß dieselbe akustische Linsenanordnung in zeitlichem Wechsel ein fokussiertes Ultraschallstrahlenbündel auf die Resistschicht aussendet und die von der Resistschicht zurückkommenden, in den Aperturbereich der
akustischen Linsenanordnung gestreuten Ultraschallstrahlen in elektrische Signale umwandelt.

7. Verfahren nach einem der Ansprüche 3 bis 6,
d a d u r c h   g e k e n n z e i c h n e t ,
daß die Phasendifferenz zwischen dem ausgesendeten
und dem empfangenen Ultraschallstrahlenbündel bestimmt wird.